# EUROPÄISCHE PATENTANMELDUNG

(11) **EP 3 618 585 A1**
(43) Veröffentlichungstag der Anmeldung: **04.03.2020**
(21) Anmeldenummer: 18192045.5
(22) Anmeldetag: 31.08.2018
(51) Int. Cl.: H05K 3/28, H05K 3/34, H05K 3/22, H05K 1/02, H05K 3/00, H01L 21/56, H05K 3/30

(54) **SCHALTUNGSTRÄGER MIT EINEM EINBAUPLATZ FÜR ELEKTRONISCHE BAUELEMENTE, ELEKTRONISCHE SCHALTUNG UND HERSTELLUNGSVERFAHREN**

(71) Anmelder: Siemens Aktiengesellschaft, 80333 München (DE)
(72) Erfinder: Blank, Rene, 12249 Berlin (DE); Heimann, Matthias, 14469 Potsdam (DE); Müller, Bernd, 16259 Falkenberg (DE); Schellenberg, Christian, 14480 Potsdam (DE); Wormuth, Dirk, 12203 Berlin (DE)

(57) **Zusammenfassung**

Die Erfindung betrifft einen Schaltungsträger 12 beziehungsweise eine elektronische Baugruppe 11 mit einem solchen Schaltungsträger 12 sowie Verfahren zur Herstellung von Schaltungsträger 12 und elektronischer Baugruppe 11. Diese weisen einen Einbauplatz 14 für ein elektronisches Bauelement 13 auf, welches durch Fügeverbindungen 16, insbesondere Sinterverbindungen gefügt wurde. Erfindungsgemäß ist vorgesehen, dass Ausnehmungen 22 und/oder Ausformungen 23 vorgesehen sind, die beim Unterfüllen eines Spaltes 18 zwischen Bauelement 13 und Schaltungsträger 12 das Unterfüllmaterial 19 lenken und so verhindern, dass dieses zu früh zusammenfließt. Ein zu frühes Zusammenfließen bewirkt nämlich, dass im Unterfüllmaterial Blasen entstehen, die die Qualität der Unterfüllung vermindern. Dies kann vorteilhaft durch die Ausnehmungen/Ausformungen verhindert werden.

## Beschreibung

Die Erfindung betrifft einen Schaltungsträger mit einem Einbauplatz für ein elektronisches Bauelement. Außerdem betrifft die Erfindung eine elektronische Schaltung mit einem solchen Schaltungsträger. Die Erfindung betrifft auch ein Verfahren zum Herstellen eines Schaltungsträgers, bei dem ein Einbauplatz für ein elektronisches Bauelement erzeugt wird. Weiterhin betrifft die Erfindung auch ein Verfahren zum Herstellen einer elektronischen Baugruppe bei dem ein solcher Schaltungsträger zum Einsatz kommt.

Schaltungsträger und elektronische Schaltungen finden in heutigen Produkten vielfache Anwendung. Insbesondere gibt es auch leistungselektronische Schaltungen, welche zum Beispiel in Gleichrichtern und Umrichtern Verwendung finden. Für eine gute thermische und elektrische Kontaktierung von Leistungshalbleitern in solchen leistungselektronischen Schaltungen muss gesorgt werden, damit deren Funktion uneingeschränkt gegeben ist. Die guten thermischen und elektrischen Eigenschaften bei gleichzeitig einer geringen Bauhöhe müssen durch die Kontaktstruktur gewährleistet sein. Bei einer Verringerung der Bauhöhe wird allerdings zusätzlich der Einsatz eines Isolationsmediums, bevorzugt um die Außenseiten des Leistungsbauelementes erforderlich.

Insbesondere im Fall von Chip-Oberseiten-Kontaktierungen von Leistungshalbleitern müssen diese Bereiche der Chipkanten und die angrenzenden auf dem Chip passivierten Leitungsbereiche mit dem Isolationsmedium verfüllt werden. Für eine einwandfreie Isolation ist es erforderlich, dass diese Verfüllung blasenfrei erfolgt. Dies stellt jedoch eine technische Herausforderung dar. Das Isolationsmaterial, welches auch als Underfill-Material (Unterfüllmatereial) bezeichnet wird, muss gewährleisten, dass während dem Verfüllen Ausgasungen aus der Fügezone nach außen dringen können und keine Blasen im Underfill-Material bilden. Insbesondere bei gesinterten Fügezonen, die für einen thermischen Aufbau gut geeignet sind, führen Ausgasen während des Verfüllens häufig zu Blasen. Als Verfüllmaterialien kommen beispielsweise folgende Underfill-Materialen zum Einsatz: Auf Unterfließen optimierte Epoxidharze mit und ohne Füllstoffe.

Die Aufgabe der Erfindung liegt daher darin, einen Schaltungsträger mit einem Einbauplatz für elektronische Bauelemente beziehungsweise eine elektronische Schaltung mit einem solchen Schaltungsträger anzugeben, bei dem die Möglichkeit eines blasenfreien Verfüllens mit einem Underfill-Material verbessert ist. Außerdem ist es Aufgabe der Erfindung ein Verfahren zum Herstellen eines solchen Schaltungsträgers sowie ein Verfahren zum Herstellen einer solchen elektronischen Baugruppe anzugeben, wobei bei diesem Verfahren ein blasenfreies Verfüllen mit Underfill-Material unterstützt wird.

Diese Aufgabe wird mit dem eingangs angegebenen Anspruchsgegenstand (Schaltungsträger) erfindungsgemäß dadurch gelöst, dass am Rand des Depots eine Ausformung vorgesehen ist.

Das Einbringen einer Ausformung, die als Vertiefung ausgebildet ist, hat beim Verfüllen des Spaltes zwischen dem Bauelement und dem Schaltungsträger den Vorteil, dass die Ausformung länger frei von Underfill-Material bleibt, als der restliche Spalt zwischen dem Bauelement und dem Schaltungsträger. Hierdurch besteht die Möglichkeit, dass Ausgasungen während des Verfüllens an der Ausformung aus diesem Fügespalt (im Folgenden kurz auch Spalt genannt) entweichen, während sich das Underfill-Material im Spalt ausbreitet. Dabei bildet das Underfill-Material eine Fließfront. Die Ausformung ist derart am Rand des Einbauplatzes angeordnet, dass die Fließfront in dem Spalt darauf zulaufen kann. Damit wird die Ausformung erst zuletzt von dem Underfill-Material verschlossen, sodass die Ausnehmung bis zuletzt die Ausgasungen nach außen transportieren kann. Die Bildung von Blasen wird daher vorteilhaft vermieden.

Der Rand des Einbauplatzes ist durch die Außenkante des einzubauenden Bauelementes definiert. Mit anderen Worten ist bei der Konzeption des Einbauplatzes auf dem Schaltungsträger zu berücksichtigen, welche Dimensionen das Bauelement, dass es zu montieren gilt, aufweist. Die Ausformung ist dann im Bereich der gedachten Außenkante des Bauelementes in dem Schaltungsträger vorzusehen. Beispielsweise kann dies so erfolgen, dass ein Teil der Ausformung am Rande des Einbauplatzes nach außen zeigt. Auf diesem Weg entsteht eine Art "Leitplanke" für die Ausgasungen und Underfill-Material, während letzteres im Spalt verteilt wird.

Der Spalt ist im Interesse einer direkten Wärmeleitung und einer geringen Bauhöhe möglichst schmal zu wählen. Insbesondere, wenn als Kontaktierungswerkstoff ein Sintermaterial zum Einsatz kommt, können vorteilhaft sehr enge Spalte realisiert werden. Diese können bei üblichen Kontaktdepots aus Sinterwerkstoff beispielsweise in einem Bereich von 20 Mikrometern bis 100 Mikrometer liegen.
Die Einbauplätze sind üblicherweise im Wesentlichen rechteckig oder quadratisch, bevorzugt auch U-förmig ausgebildet. Besonders vorteilhaft ist es, wenn die Ausnehmungen am Rand des alten Bauplatzes derart angeordnet werden, dass diese sich in der Mitte zwischen den Ecken des Einbauplatzes befinden. Ein Unterfüllen des Spaltes kann dann besonders vorteilhaft von den Ecken ausgehend erfolgen, sodass sich die Fließfronten von den Ecken des Einbauplatzes zu den Ausformung hinbewegen und die Ausformung zuletzt erreichen. Sollte hierbei die Fließfront von einer Ecke schneller als von der anderen Ecke zu der Ausformung gelangen, stellt die Ausformung vorteilhaft ein Fließhindernis dar, da das Unterfüll-Material einen Widerstand überwinden muss, um die Kante der Ausformung zu umfließen. Hierdurch hält die Ausformung vorteilhaft längere Zeit einen für ein Ausgasen erforderlichen Weg geöffnet, der sich erst schließt, wenn die Fließfronten des Underfill-Materials sich aus entgegengesetzten Richtungen an der Ausformung treffen. Das Ergebnis ist ein blasenfreies oder zumindest weitgehend blasenfreies Unterfüllungsergebnis.

Da das Depot aus einem Sinterwerkstoff besteht, ist es möglich, Ausformungen vorzusehen, die einer vergleichsweise feine Geometrie aufweisen. Dies liegt daran, dass die Sinterdepots ihre Form während des Fügens im Wesentlichen beibehalten (wenn man von einer Schrumpfung einmal absieht), sodass diese feinen Strukturen erhalten bleiben. Anders ist dies bei Lotwerkstoffen, welche zur Herstellung der Verbindung aufgeschmolzen werden. Hierbei würden feine Ausformungen aufgrund der Oberflächenspannung des flüssigen Lotwerkstoffes verloren gehen.

Die Ausformungen unterstützen vorteilhaft die Ausleitung von Ausgasungen während des Verfüllens des Spaltes mit Unterfüllmaterial. Hierbei kommt den Ausformungen die Aufgabe zu, das Unterfüllmaterial, wenn dieses mit seiner Fließfront an der Ausformung ankommt, in eine bestimmte Richtung zu leiten, sodass beispielsweise verhindert werden kann, dass dieses in Bereiche vordringt, in denen Blasen eingeschlossen werden können. Vorteilhaft können die Ausformungen dabei auch so eingesetzt werden, dass die Leitung der Fließfront hin zu einem Fließhindernis wie einer Ausnehmung in Form einer Vertiefung erfolgt (hierzu im Folgenden noch mehr). Die Ausnehmungen, welche als Fließhindernis eine Kante der Vertiefung zur Verfügung stellen, führen dann dazu, dass die Fließfront solange gestoppt wird, bis sich am Ende die Ausnehmung auch mit Unterfüllmaterial füllt. Bis dahin kann die Ausnehmung als Kanal zum Transport von Ausgasungen verwendet werden.

Aber auch ohne die zusätzliche Wirkung der Ausnehmungen können die Ausformungen durch Umleiten der Fließfronten oder Aufhalten der Fließfronten verhindern, das Unterfüllmaterial, welches beispielsweise von verschiedenen Ecken eines Einbauplatzes den Spalt ausfüllt, zu früh zusammenfließt und so ein Ausgasen mit der Konsequenz einer Blasenbildung verhindern würde.

Die Ausformungen können, wenn man quadratische oder rechteckige Einbauplätze voraussetzt, bei diesen jeweils in der Mitte zwischen zwei Ecken angeordnet sein. Dies bedeutet, dass das ebenfalls rechteckige Depot aus Sinterwerkstoff ebenfalls rechteckig oder quadratisch ist und jeweils in der Mitte zwischen den Ecken die Ausformung aufweist.

Als Ausformung im Sinne der Erfindung soll eine Struktur verstanden werden, welche vom Rand des Depots aus Sinterwerkstoff absteht und so ein Hindernis ausbildet, welches eine entlang des Depots fließendes Unterfüllmaterial aufhält oder umlenkt.

Gemäß einer Ausgestaltung der Erfindung ist vorgesehen, dass die Ausformung die Form eines Keils hat, der von dem Rand des Depots absteht.

Eine keilförmige Ausformung ist so angeordnet, dass der Keil sozusagen auf seiner dreieckigen Fläche liegt. Mit anderen Worten kann man sich die keilförmige Ausformung als Prisma mit einer dreieckigen Grundfläche vorstellen, wobei dieses Prisma mit einem seiner Seitenflächen an das Depot anschließt.

Gemäß einer Ausgestaltung der Erfindung ist vorgesehen, dass die Breite des Keils gerade der Höhe des Depots entspricht.

Besonders vorteilhaft ist es, wenn der Keil den Spalt moglichst auf seiner gesamten Spalthöhe ausfüllt. Da die Spaltbreite allerdings durch die Höhe des Lotdepots gegeben ist, ist dies nur der Fall, wenn die Breite des Keils gerade der Höhe des Depots entspricht. Hierdurch wird die umleitende Funktion der Ausformung vorteilhaft am effektivsten genutzt. Außerdem lässt sich eine solche Ausformung, die der Höhe des Sinterdepots entspricht, am einfachsten herstellen. Hierbei kommt eine Maske zum Einsatz, welche eine die Ausformung enthaltende Maskenöffnung aufweist, wobei die Ausfüllung dieser Maskenöffnung neben dem Depot aus Sinterwerkstoff gleichzeitig die Ausformung in derselben Höhe erzeugt.
Gemäß einer Ausgestaltung der Erfindung ist vorgesehen, dass auf dem Einbauplatz ein Depot eines Fügehilfsstoffes, insbesondere aus einem Sinterwerkstoff, aufgetragen ist.

Selbstverständlich kann die Ausformung auch andere Geometrien als die eines Keils aufweisen. Diese kann beispielsweise auch quaderförmig ausgebildet sein, wobei das Quader sozusagen an die Seite des Depots aus Sinterpaste anschließt. Auch hier ist es vorteilhaft, wenn der Quader dieselbe Höhe aufweist, wie das Depot.

Eine andere Möglichkeit besteht darin, dass die Ausformung die Form eines Halbzylinders aufweist, der mit seiner flachen Seitenfläche an das Depot aus Sinterpaste anschließt. Auch hier ist es vorteilhaft, wenn die Höhe dieses Halbzylinders der Höhe des Depots entspricht.

Wenn der Fügehilfsstoff, also dem Sinterwerkstoff, auf dem Schaltungsträger bereits vorgesehen ist, erleichtert dies vorteilhaft die Montage des Bauelementes. Zu Montagezwecken wird der Schaltungsträger üblicherweise bereits mit Fügehilfsstoff versehen. Dieser kann beispielsweise aus Sinterpaste gedruckt werden. Falls bei diesem Prozess Druckfehler auftreten, kann dies vor Montage der Bauelemente optisch ermittelt werden, sodass frühzeitig ein Ausschuss beziehungsweise eine Korrektur dieses Fehlers erfolgen kann. Alternativ können auch Preforms (Formteile) verwendet werden, die vorteilhaft besonders präzise hergestellt werden können. Diese werden im Einbauplatz fixiert oder direkt vor der Montage des Bauelementes aufgelegt.

Gemäß einer Ausgestaltung der Erfindung ist vorgesehen, dass der Einbauplatz an seinem Rand mindestens eine Ausnehmung aufweist, die eine Vertiefung in der Oberfläche des Schaltungsträgers ausbildet. Als Oberflächenstrukturierung wird eine Anpassung der Oberfläche dahingehend verstanden, dass diese als Fließhindernis für das Underfill-Material zum Einsatz kommt. Dies kann beispielsweise erreicht werden, indem die Oberfläche beispielsweise mit einem Laser aufgerauht wird. Im Folgenden werden die Vorteile der Erfindung jeweils anhand der Ausnehmungen erläutert. Selbstverständlich gelten diese analog aber auch bei Verwendung der Oberflächenstrukturierung.

Das zusätzliche Einbringen einer Ausnehmung, die als Vertiefung ausgebildet ist, hat beim Verfüllen des Spaltes zwischen dem Bauelement und dem Schaltungsträger den Vorteil, dass die Ausnehmung länger frei von Underfill-Material bleibt, als der restliche Spalt zwischen dem Bauelement und dem Schaltungsträger. Hierdurch besteht die Möglichkeit, dass Ausgasungen während des Verfüllens durch die Vertiefung aus diesem Fügespalt (im Folgenden kurz auch Spalt genannt) entweichen, während sich das Underfill-Material im Spalt ausbreitet. Dabei bildet das Underfill-Material eine Fließfront. Die Ausnehmung ist derart am Rand des Einbauplatzes angeordnet, dass die Fließfront in dem Spalt darauf zulaufen kann. Damit wird die Ausnehmung erst zuletzt von dem Underfill-Material verschlossen, sodass die Ausnehmung bis zuletzt die Ausgasungen nach außen transportieren kann. Die Bildung von Blasen wird daher vorteilhaft vermieden.

Der Rand des Einbauplatzes ist durch die Außenkante des einzubauenden Bauelementes definiert. Mit anderen Worten ist bei der Konzeption des Einbauplatzes auf dem Schaltungsträger zu berücksichtigen, welche Dimensionen das Bauelement, dass es zu montieren gilt, aufweist. Die Ausnehmung ist dann im Bereich der gedachten Außenkante des Bauelementes in dem Schaltungsträger vorzusehen. Beispielsweise kann dies so erfolgen, dass ein Teil der Ausnehmung innerhalb des Einbauplatzes und ein Teil der Ausnehmung außerhalb des Einbauplatzes liegt. Auf diesem Weg entsteht eine Art Kanal oder "Tunnel" für die Ausgasungen, während das Underfill-Material im Spalt verteilt wird.

Gemäß einer Ausgestaltung der Erfindung ist vorgesehen, dass die Ausnehmung aus einem Schlitz besteht, der senkrecht zum Rand des Einbauplatzes verläuft.

Wie bereits erwähnt, soll die Ausnehmung am Rand des Einbauplatzes die gedachte Kante des Bauelementes durchlaufen, sodass die Ausnehmung Ausgasungen aus dem Einbauplatz nach außen transportieren kann. Ein Schlitz, welcher senkrecht zum Rand des Einbauplatzes verläuft, kann jenseits und diesseits des Randes des Einbauplatzes liegen und erfüllt diese Aufgabe daher besonders gut. Außerdem lässt sich ein solcher Schlitz vorteilhaft einfach beispielsweise durch Mikrofräsen oder Laserbearbeitung erzeugen.

Gemäß einer Ausgestaltung der Erfindung ist vorgesehen, dass die Vertiefung in einer die Oberfläche des Schaltungsträgers bildenden Isolationsschicht, insbesondere bestehend aus einem Lötstopplack, und/oder in einer Metallisierung auf dem Schaltungsträger vorgesehen ist.

Wird die Vertiefung, beispielsweise der Schlitz, in der Oberfläche des Schaltungsträger erzeugt, stehen zu dessen Ausbildung alle Lagen des Schichtaufbaus des Schaltungsträgers zur Verfügung. Die Isolationsschicht wird normalerweise an den Einbauplatz herangeführt und endet in einem bestimmten Abstand des Einbauplatzes, damit dieser zuverlässig von Isoliermaterial freigehalten werden kann. Besteht diese Schicht beispielsweise aus einem Lötstoplack, wird dieser üblicherweise fotochemisch entwickelt. Hierbei können die Ausnehmungen von Anfang an berücksichtigt werden und in situ mit der Herstellung mit der Lötstopschicht ausgebildet werden.

Eine andere Möglichkeit besteht darin, die Metallisierung auf dem Schaltungsträger für die Erzeugung der Ausnehmung zu nutzen. Auch die Metallisierung ist als Lage auf dem Schaltungsträger aufgebracht und wird zur Ausbildung von Kontaktflächen und Leiterbahnen strukturiert. Bei diesem Strukturierungsprozess (beispielsweise ätztechnisch) kann die Vertiefung vorteilhaft während des Prozessierens in situ hergestellt werden.

Selbstverständlich ist es auch möglich andere Fertigungsverfahren für die Ausnehmung vorzusehen. Sowohl in der Isolationsschicht als auch in der Metallisierung können die Ausnehmungen beispielsweise durch Mikrofräsen oder Laserbearbeitung ausbildet werden. Diese Verfahren haben den Vorteil einer sehr hohen Genauigkeit, sodass die Ausnehmungen präzise hergestellt werden können. Insbesondere die für ein Stoppen der Fließfront des Underfill-Materials erforderlichen scharfen Kanten der Vertiefung können durch diese Verfahren hervorragend ausgebildet werden. Außerdem ist es möglich, mittels Fräsens oder Laserbearbeitung auch Ausnehmungen herzustellen, die bis in das Material des Schaltungsträgers hinabreichen. Tiefere Ausnehmungen haben den Vorteil, dass Ausgasungen noch zuverlässiger nach außen transportiert werden können.

Die Aufgabe wird alternativ mit dem eingangs angegebenen Anspruchsgegenstand (elektronische Schaltung) erfindungsgemäß auch dadurch gelöst, dass der Schaltungsträger gemäß der Erfindung ausgebildet ist, wobei das elektronische Bauelement auf dem Depot des Fügehilfsstoffes befestigt ist.

Bei der elektronischen Schaltung handelt es sich um eine Umsetzung, bei der für das Endprodukt der Schaltungsträger genutzt wird, der vorstehend bereits eingehend erläutert wurde. Wird eine solche elektronische Baugruppe mit Underfill-Material unterfüllt, lassen sich dadurch blasenfreie Unterfüllergebnisse erzielen, wodurch die obenstehende Aufgabe gelöst wird. Das blasenfreie Unterfüllmaterial verbessert vorteilhaft sowohl die Wärmeleitung als auch die elektrische Isolation in der elektronischen Baugruppe.

Gemäß einer Ausgestaltung der Erfindung ist vorgesehen, dass ein Spalt zwischen dem Schaltungsträger und dem Bauelement mit einem Underfill-Material ausgefüllt ist.

Die Aufgabe wird alternativ mit dem eingangs angegebenen Anspruchsgegenstand (Maske) erfindungsgemäß auch dadurch gelöst, dass die mindestens eine Öffnung am Rand Einbuchtungen aufweist, wobei mit den Einbuchtungen Depots mit Ausformungen druckbar sind.

### 10. Einschub

Die Aufgabe wird alternativ mit dem eingangs angegebenen Anspruchsgegenstand (Verfahren) erfindungsgemäß auch dadurch gelöst, dass am Rand des Depots eine Ausformung vorgesehen wird.

Wird bei dem Verfahren eine Ausformung erzeugt, so kann das erzeugte Produkt, nämlich der Schaltungsträger, vorteilhaft verwendet werden, um die vorstehend erläuterte elektronische Baugruppe zu erzeugen. Die hiermit verbundenen Vorteile sind bereits genannt worden und sollen an dieser Stelle nicht noch einmal erwähnt werden.

Gemäß einer Ausgestaltung der Erfindung ist vorgesehen, dass die Ausformung in Form eines Keils hergestellt wird, der von dem Rand des Depots absteht.

Die keilförmige Ausbildung der Ausformung hat den Vorteil, dass diese Struktur für eine Umleitung von Underfill-Material eine günstige Geometrie aufweist. Selbstverständlich können die Strukturen auch andere Geometrie haben, wie vorstehend bereits erläutert wurde.

Gemäß einer Ausgestaltung der Erfindung ist vorgesehen, dass der Keil mit einer Breite hergestellt wird, die gerade der Höhe des Depots entspricht.

Der Vorteil, der damit verbunden ist, dass der detailgenau die Höhe des Depots aufweist, ist bereits vorstehend erläutert worden. Daher soll an dieser Stelle nicht noch einmal genauer darauf eingegangen werden. Der Vorteil besteht, wie gesagt darin, dass die Herstellung vereinfacht und die leitende Wirkung des Keils optimiert ist.

Gemäß einer Ausgestaltung der Erfindung ist vorgesehen, dass am Rand des Einbauplatzes mindestens eine Ausnehmung erzeugt wird, wobei diese als Vertiefung in der Oberfläche des Schaltungsträgers ausgebildet wird.

Gemäß einer Ausgestaltung der Erfindung ist vorgesehen, dass die Ausnehmung durch ein spanendes Verfahren, insbesondere durch Fräsen oder Bohren erzeugt wird.

Wie bereits erläutert gestatten spanende Verfahren wie zum Beispiel Mikrofräsen oder Bohren besonders hohe Genauigkeiten. Insbesondere lassen sich in den Ausnehmungen die erforderlichen Kanten, welche den Rand der Vertiefung bilden, scharfkantig ausbilden.

Beim Fräsen können längliche Ausnehmungen erzeugt werden. Je nach dem, ob die Drehachse des Fräskopfes senkrecht oder parallel zur Oberfläche des Schaltungsträgers liegt, können die länglichen Ausnehmungen rundherum eine scharfe Kante aufweisen oder an ihren Enden eine auslaufende Kante aufweisen. Die auslaufende Kante am Ende der Ausnehmungen können als Fließhilfe verwendet werden, damit sich die Ausnehmung am Ende des Unterfüllprozesses noch mit Unterfüllmaterial ausfüllt.

Gemäß einer Ausgestaltung der Erfindung ist vorgesehen, dass Ausnehmung durch Strukturieren einer Schicht, insbesondere durch Strukturieren einer Isolationsschicht auf dem Schaltungsträger erzeugt wird.

Wie bereits erwähnt ist es auch möglich, durch Strukturieren der Schicht Ausnehmungen zu erzeugen. Der Vorteil dieses Fertigungsverfahrens liegt darin, dass die Strukturierung ohnehin erfolgen muss und hierbei für die Ausbildung der Ausnehmungen kein zusätzlicher Fertigungsaufwand entsteht.

Die Aufgabe wird alternativ mit dem eingangs angegebenen Anspruchsgegenstand (Verfahren) erfindungsgemäß auch dadurch gelöst, dass ein Schaltungsträger nach einem Verfahren gemäß dem vorstehend erläuterten Verfahren hergestellt wird,
- auf dem Depot ein elektronisches Bauelement befestigt wird,
- ein Spalt zwischen Schaltungsträger und Bauelement mit einem Underfill-Material ausgefüllt wird.

Die Vorteile des Montageverfahrens für die elektronische Baugruppe sind bereits eingehend erläutert worden. Hierbei ist es notwendig, die Depots mit den Ausformungen auf den Schaltungsträger aufzubringen, wobei auf diesem die elektronischen Bauelemente zwecks Endmontage aufgesetzt werden. Dann wird der Spalt mit dem Underfill-Material ausgefüllt, wobei, wie bereits erläutert, ein blasenfreies Unterfüllergebnis erreicht werden kann.

Gemäß einer Ausgestaltung der Erfindung ist vorgesehen, dass das Underfill-Material in einem Bereich außerhalb der mindestens eine Ausformung, vorzugsweise genau in der Mitte zwischen zwei Ausformungen, in den Spalt eingebracht wird.

Das Unterfüllmaterial dehnt sich, wenn es in der Mitte zwischen zwei Ausformungen eingebracht wird, vorteilhaft zu beiden Seiten gleichmäßig aus. Sollte dies nicht der Fall sein, dienen die Ausformungen als Fließhindernis, um diese Ungleichmäßigkeiten zu beseitigen. Daher ist ein zuverlässiges Ausgasen leicht möglich. Wenn, wie bereits erläutert, ein quadratischer oder rechteckiger Einbauplatz vorgesehen ist und die Ausformungen in der Mitte der Seitenkanten vorgesehen sind, so befindet sich die Mitte zwischen den Ausformungen üblicherweise an den Ecken (bei quadratischen Einbauplätzen oder nahe der Ecken (bei rechteckigen Einbauplätzen).

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:
Figur 1 ein Ausführungsbeispiel der erfindungsgemäßen elektronischen Baugruppe mit einem Ausführungsbeispiel des erfindungsgemäßen Schaltungsträgers als Schnittbild,
Figur 2 die Aufsicht auf ein Ausführungsbeispiel des erfindungsgemäßen Schaltungsträgers,
Figur 3 und 4 Ausführungsbeispiele für verschiedene Ausnehmungen und Ausformungen in der erfindungsgemäßen elektronischen Baugruppe gemäß Figur 1, geschnitten,
Figur 5 bis 7 Ausführungsbeispiele für Ausformungen von Sinterdepots gemäß Ausführungsbeispielen des erfindungsgemäßen Schaltungsträgers, dreidimensional,
Figur 8 eine Metallisierung mit Ausnehmungen als Ausführungsbeispiel des erfindungsgemäßen Schaltungsträgers als Aufsicht,
Figur 9 den Schaltungsträger gemäß Figur 8 mit aufgesetzten Sinterpastendepots als Aufsicht,
Figur 10 eine Maske, mit der das Ausführungsbeispiel der Sinterpastendepots gemäß Figur 9 gedruckt werden kann, als Aufsicht.

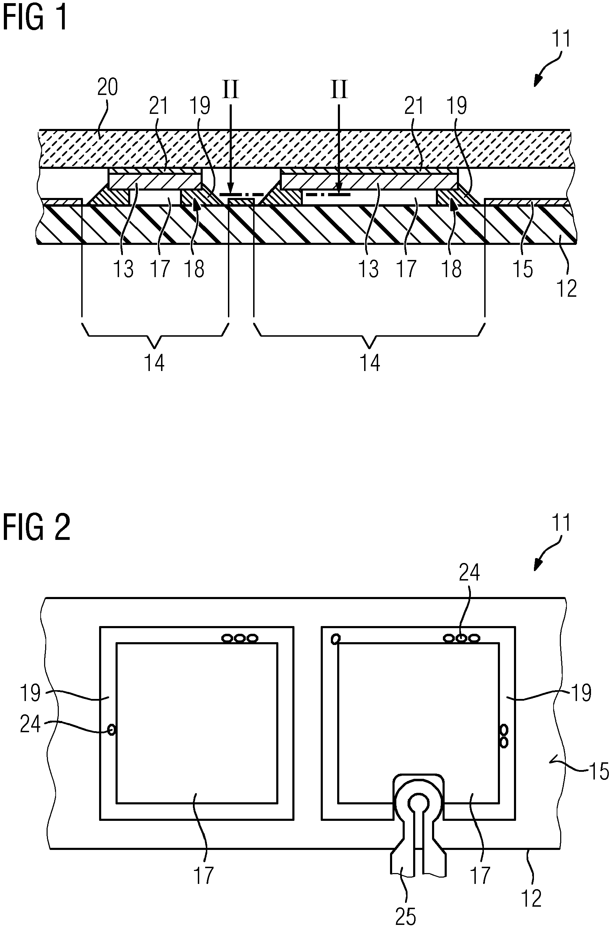

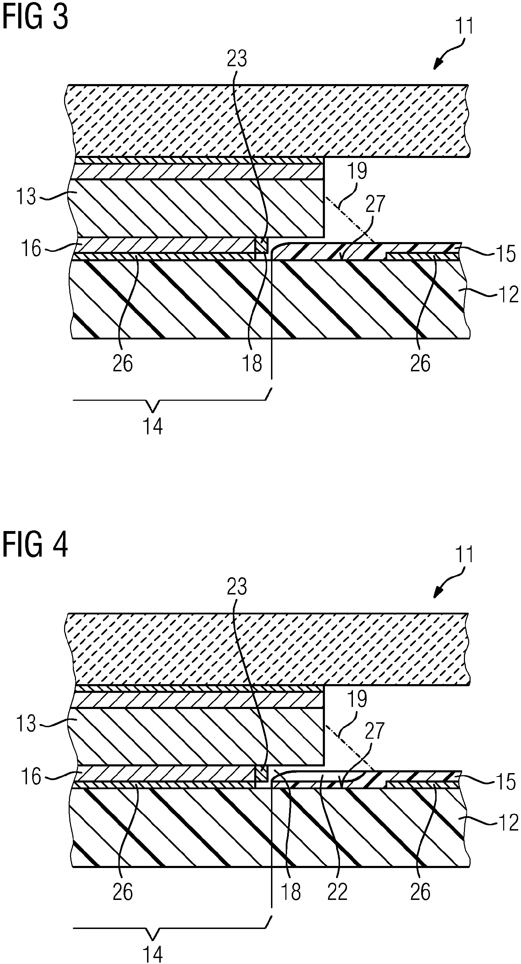

Gemäß Figur 1 ist eine elektronische Schaltung 11 dargestellt welche einen Schaltungsträger 12 und elektronische Bauelemente 13 aufweist. Die elektronischen Bauelemente 13 sind jeweils auf Einbauplätzen 14 des Schaltungsträgers 12 vorgesehen. Die Einbauplätze 14 entstehen dadurch, dass in einer Isolationsschicht 15 aus einem Lötstoplack Öffnungen ausgebildet sind. In diesen Öffnungen ist jeweils ein Depot 16 auf der Oberfläche des Schaltungsträgers 12 vorgesehen (vergleiche beispielsweise Figur 3) jeweils einer Sinterverbindung 17 umgeschmolzen wurde. Ein verbleibender Spalt 18 ist mit einem Underfill-Material 19 ausgefüllt, welches den Spalt zwischen dem Bauelement 13 und dem Schaltungsträger 12 verschließt. Außerdem weist die elektronische Schaltung 11 eine Deckplatte 20 auf welche jeweils über eine weitere Sinterverbindung 21 mit den jeweiligen Oberseiten der Bauelemente 13 verbunden ist.

In Figur 1 ist die elektronische Schaltung 11 ohne jegliche Ausnehmungen 22 oder Ausformungen 23 (vergleiche aber Figuren 3 bis 7) dargestellt. Die in diesen Figuren dargestellten Ausformungen und Ausnehmungen können jedoch vor oder hinter der Schnittebene liegen, die in Figur 1 dargestellt ist. Insofern können die Varianten gemäß den genannten Figuren in die elektronische Schaltung 11 gemäß Figur 1 eingebracht werden.

Figur 1 zeigt jedoch auch einen Aufbau, wie dieser gemäß dem Stand der Technik ohne jegliche Ausnehmungen und Ausformungen aussehen würde. Ein solcher Aufbau wurde zu Testzwecken hergestellt, wobei dieser Aufbau in der Schnittebene II - II (siehe Figur 1) aufgeschnitten wurde. Zu erkennen ist in dieser Schnittebene eine Schlifffläche, welche durch die Sinterverbindung 17 ausgebildet ist. Diese Sinterverbindung 17 ist von dem Underfill-Material 19 umgeben. Da die elektronische Schaltung 11 gemäß Figur 2 ohne Ausnehmungen und Ausformungen hergestellt wurde, sind beim Vergießen des Spaltes 18 (vergleiche Figur 1) in dem Underfill-Material Blasen 24 entstanden, die ihren Ursprung durch Ausgasungen der Sinterverbindung 17 haben. Diese Blasenbildung gilt es mit den erfindungsgemäßen Ausformungen und Ausnehmungen zu verhindern.

In Figur 2 ebenfalls zu erkennen sind Kontaktstrukturen 25, die aus Leiterbahnen zum Kontaktieren des in Figur 2 nicht dargestellten elektronischen Bauelements 21 (vergleiche Figur 1) dienen.

In Figur 3 ist ein Ausschnitt aus der elektronischen Baugruppe dargestellt, die gemäß Figur 1 aufgebaut sein kann. Der Ausschnitt stellt einen Rand der Ausnehmung 14 dar, in dem auch das Bauelement 13 zu erkennen ist. Anders als in Figur 1 wird jedoch der Rand der Ausnehmung 14 durch die Isolationsschicht 15 unterhalb des Bauelementes 13 gebildet. Allerdings reicht die Isolationsschicht 15 nicht an das Depot 16 aus einem Sinterwerkstoff heran, welches auf einer Kontaktschicht aufgebracht ist, die Teil einer strukturierten Metallisierung 26 ist. Die Metallisierung 26 sowie die Isolationsschicht 15 befinden sich jeweils auf der Oberfläche 27 des Schaltungsträgers 12.

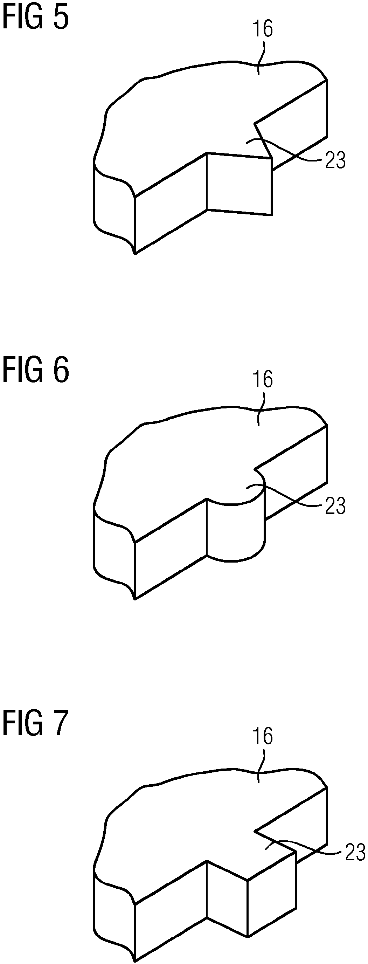

Gemäß Figur 3 ist außerdem die Ausformung 23 zu erkennen, welche an das Depot 26 angeschlossen ist und beispielsweise keilförmig, in Form eines Halbzylinders oder quaderförmig ausgebildet sein kann. Wie den Figuren 5 bis 7 zu entnehmen ist, schließt sich diese Ausformung 23 jeweils in der Mitte des Depots 16 an die Außenseite an und steht von dieser ab (deswegen der Begriff Ausformung). Die Sinterdepots 16 haben den Vorteil, dass diese Ausformung auch nach der Wärmebehandlung zwecks Fügens der Sinterverbindung erhalten bleibt, da die Sinterkörper, die die Depots 16 bilden, während des Fugens formstabil bleiben.

In den Figuren 5 bis 7 lässt sich außerdem die jeweilige Geometrie der Ausformungen entnehmen. Diese weisen die Höhe des Depots 16 auf und sind jeweils an die Außenkanten angeschlossen. Gemäß Figur 5 besteht die Ausformung aus einem Keil. Dieser ist mit anderen Worten ein Dreiecksprisma, wobei dieses mit einem seiner drei Seitenflächen an die Außenseite des Depots 16 anschließt und somit mit der gegenüberliegenden Spitze von der Seitenkante abragt. Die Grund- und die Deckfläche dieses Prismas sind damit auf der Ebene jeweils der Unterseite und der Oberseite des Depots 16.

Gemäß Figur 6 ist die Ausformung 23 als Halbzylinder ausgebildet, wobei dieser mit dem Teil der runden Mantelfläche nach außen abragt und mit der geraden Schnittfläche auf der Seitenfläche des Depots 16 liegt. Grundfläche und Deckfläche sind damit jeweils wieder mit der Oberseite und der Unterseite des Depots 16 auf einer Ebene.

Gemäß Figur 7 ist die Ausformung 23 würfelförmig ausgebildet, wobei eine der Seitenflächen dieses Würfels auf der Seitenfläche des Depots 16 liegt. Die obere und die untere Würfelseite bilden jeweils eine gemeinsame Fläche mit der Oberseite und der Unterseite des Depots 16.

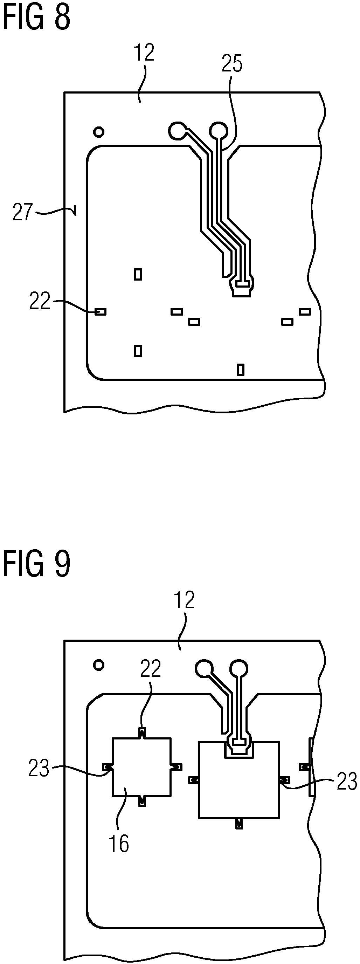

In Figur 8 ist der Schaltungsträger 12 mit einer Metallisierung zu erkennen, welcher neben den Kontaktstrukturen 25 auch die Ausnehmungen 22 aufweist. Die hierfür erforderlichen Aussparungen können beispielsweise durch Ätzen in der Metallisierung hergestellt werden. Zu diesem Zweck ist es erforderlich, eine Druckmaske zu verwenden, die eine Negativform der in Figur 3 dargestellten Metallstrukturen ausbildet. Mit anderen Worten weist eine solche Maske überall dort Ätzöffnungen auf, wo gemäß Figur 8 die Oberfläche 27 des Schaltungsträgers 12 zu Tage tritt.

In Figur 9 ist dargestellt, wie auf dem Schaltungsträger 12 gemäß Figur 8 die Depots 16 aus Sinterpaste aufgebracht wurden. Hier ist auch zu erkennen, dass die Ausformungen 23 mit den Ausnehmungen 22 korrespondieren, sodass der zu Figur 4 beschriebene Effekt einer Umleitung des Underfill-Materials erreicht werden kann. Außerdem ist zu erkennen, dass die Depots 16 aus Sinterpaste für manche Bauelemente aus mehreren Segmenten bestehen, um unterschiedliche Kontakte des zu fügenden elektronischen Bauelementes (in Figur 9 nicht dargestellt) zu gewährleisten.

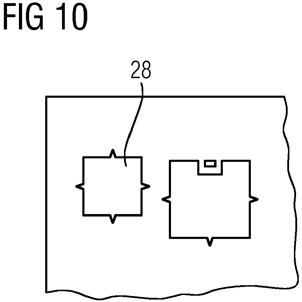

Gemäß Figur 10 ist eine Druckschablone dargestellt, welche Maskenöffnungen 28 an den Stellen aufweist, die die Depots 16 gemäß Figur 9 gedruckt werden sollen. Zu erkennen ist, dass die Ausformungen 23 gemäß Figur 9 durch Einbuchtungen 29 in den Maskenöffnungen 28 realisiert sind. Diese werden beim Drucken mit dem Material, beispielsweise der Sinterpaste, ausgefüllt, damit die Depots 16 die Ausformungen 23 ausweisen.

### Bezugszeichen

- 11: elektronische Schaltung
- 12: Schaltungsträger
- 13: elektronische Bauelemente
- 14: Einbauplätze
- 15: Isolationsschicht
- 16: Depot
- 17: Sinterverbindung
- 18: Spalt
- 19: Underfill-Material
- 20: Deckplatte
- 21: weitere Sinterverbindung
- 22: Ausnehmungen
- 23: Ausformungen
- 24: Blasen
- 25: Kontaktstrukturen
- 26: Metallisierung
- 27: Oberfläche
- 28: Maskenöffnungen
- 29: Einbuchtungen

## Patentansprüche

1. Schaltungsträger mit einem Einbauplatz für ein elektronisches Bauelement, wobei auf dem Einbauplatz ein Depot eines Fügehilfsstoffes aus einem Sinterwerkstoff aufgetragen ist,
**dadurch gekennzeichnet,**
**dass** am Rand des Depots eine Ausformung vorgesehen ist.

2. Schaltungsträger nach Anspruch 1,
**dadurch gekennzeichnet,**
**dass** die Ausformung die Form eines Keils, Halbzylinders oder Quaders hat, der von dem Rand des Depots absteht.

3. Schaltungsträger nach Anspruch 2,
**dadurch gekennzeichnet,**
**dass** die Breite des Keils mindestens der Höhe des Depots entspricht.

4. Schaltungsträger nach einem der voranstehenden Ansprüche,
**dadurch gekennzeichnet,**
**dass** der Einbauplatz an seinem Rand mindestens eine Ausnehmung aufweist, die eine Vertiefung in der Oberfläche des Schaltungsträgers ausbildet, oder eine Oberflächenstrukturierung, die eine schwerere Benetzbarkeit für das Underfill-Material aufweist

5. Schaltungsträger nach Anspruch 4,
**dadurch gekennzeichnet,**
**dass** die Ausnehmung aus einem Schlitz besteht, der senkrecht zum Rand des Einbauplatzes verläuft.

6. Schaltungsträger nach einem der Ansprüche 4 oder 5,
**dadurch gekennzeichnet,**
**dass** die Vertiefung in einer die Oberfläche des Schaltungsträgers bildenden Isolationsschicht, insbesondere bestehend aus einem Lötstopplack, und/oder in einer Metallisierung auf dem Schaltungsträger vorgesehen ist.

7. Elektronische Schaltung mit einem Schaltungsträger und einem elektronischen Bauelement,
**dadurch gekennzeichnet,**
**dass** der Schaltungsträger nach einem der Ansprüche 1 bis 7 ausgebildet ist, wobei das elektronische Bauelement auf dem Depot des Fügehilfsstoffes befestigt ist.

8. Elektronische Schaltung nach Anspruch 7,
**dadurch gekennzeichnet,**
**dass** ein Spalt zwischen dem Schaltungsträger und dem Bauelement mit einem Underfill-Material ausgefüllt ist.

9. Maske zum Drucken von Sinterpaste, wobei die Maske mindestens eine Öffnung zur Applikation der Sinterpate auf ein Substrat aufweist,
**dadurch gekennzeichnet,**
**dass** die mindestens eine Öffnung am Rand Einbuchtungen aufweist, wobei mit den Einbuchtungen Depots mit Ausformungen druckbar sind.

10. Verfahren zum Herstellen eines Schaltungsträgers, bei dem ein Einbauplatz für ein elektronisches Bauelement erzeugt wird, wobei auf dem Einbauplatz ein Depot aus einem Fügehilfsstoff aufgebracht oder angebracht wird,
**dadurch gekennzeichnet,**
**dass** am Rand des Depots eine Ausformung vorgesehen wird.

11. Verfahren nach Anspruch 10,
**dadurch gekennzeichnet,**
**dass** die Ausformung in Form eines Keils hergestellt wird, der von dem Rand des Depots absteht.

12. Verfahren nach Anspruch 11,
**dadurch gekennzeichnet,**
**dass** der Keil mit einer Breite hergestellt wird, die gerade der Höhe des Depots entspricht.

13. Verfahren nach einem der Ansprüche 10 bis 12,
**dadurch gekennzeichnet,**
**dass** am Rand des Einbauplatzes mindestens eine Ausnehmung erzeugt wird, wobei diese als Vertiefung in der Oberfläche des Schaltungsträgers ausgebildet wird.

14. Verfahren zum Herstellen einer elektronischen Baugruppe, **dadurch gekennzeichnet,**
**dass**
• ein Schaltungsträger nach einem Verfahren gemäß Anspruch 13 hergestellt wird,
• auf dem Depot ein elektronisches Bauelement befestigt wird,
• ein Spalt zwischen Schaltungsträger und Bauelement mit einem Underfill-Material ausgefüllt wird.

15. Verfahren nach Anspruch 14,
**dadurch gekennzeichnet,**
**dass** das Underfill-Material in einem Bereich außerhalb der mindestens eine Ausformung, vorzugsweise genau in der Mitte zwischen zwei Ausformungen, in den Spalt eingebracht wird.
